# EUROPEAN PATENT SPECIFICATION

(11) **EP 1 123 166 B1**
(45) Date of publication and mention of the grant of the patent: **06.12.2006**
(21) Application number: 99943798.1
(22) Date of filing: 20.08.1999
(51) Int. Cl.: B08B 3/00, B08B 3/10, B08B 3/12, B08B 7/00, C23G 1/00

(54) **METHOD OF REMOVING ORGANIC MATERIALS FROM SUBSTRATES**
VERFAHREN ZUR ENTFERNUNG ORGANISCHEN MATERIALS VON TRÄGERN
PROCEDE D'ELIMINATION DE MATIERES ORGANIQUES DE SUBSTRATS

(30) Priority: 27.08.1998 US 141443
(43) Date of publication of application: 16.08.2001
(73) Proprietor: Best Label Company, Inc., Cerritos, CA 90703 (US)
(72) Inventor: WALEH, Ahmad, Palo Alto, CA 94301 (US); LEVENSON, Eric, O., Los Altos, CA 94024 (US)
(74) Representative: Carpmaels & Ransford
(86) International application number: PCT/US1999/019018
(87) International publication number: WO 2000/012231

(56) References cited:
- WO-A-89/00895
- US-A- 4 363 673
- US-A- 5 037 506
- US-A- 5 227 001
- US-A- 5 763 016

## Description

### 1. Field of the Invention

The present invention is related to the removal, cleaning, and stripping of a wide variety of organic materials which may be deposited or formed on substrates during the manufacture, repair or rework of those substrates. Organic materials which may be removed, cleaned, or stripped with this method include organic coatings, films, layers and residues consisting of, for example, photosensitive and non-photosensitive organic materials, polymerized photoresists, cured and uncured polyimides, polycarbonates, paints, resins, multilayer organic polymers, certain organo-metallic complexes, positive optical photoresist, negative optical photoresist, chemically amplified photoresists, electron-beam photoresists, X-ray photoresists, ion-beam photoresists, and ion-implanted and other hardened photoresists. Substrates from which these organic coatings, films, layers and residues may be removed with this method include semiconductor devices and wafers, ceramic devices, liquid crystal display devices, photomasks, flat-panel displays, printed circuit boards, printed wiring boards, magnetic read/write heads, thin-film read/write heads.

### 2. Description of the Related Art

The removal, cleaning, or stripping of organic coatings, films, layers and residues consisting of, for example, photosensitive and non-photosensitive organic materials, polymerized photoresists, cured and uncured polyimides, polycarbonates, paints, resins, multilayer organic polymers, certain organo-metallic complexes, positive optical photoresist, negative optical photoresist, chemically amplified photoresists, electron-beam photoresists, X-ray photoresists, ion-beam photoresists, and ion-implanted and other hardened photoresists is one of the necessary steps in the manufacture and repair of semiconductor devices and wafers, ceramic devices, liquid crystal display devices, photomasks, flat-panel displays, printed circuit boards, printed wiring boards, magnetic read/write heads, thin-film read/write heads. The removal, cleaning and stripping of such organic materials is usually carried out by one of three general techniques, including (1) dry methods, which include dry-ashing or plasma ashing, dry-stripping, dry-etching, and the use of various procedures which make use of kinetic processes such as abrasives, cryogenic aerosol techniques, CO₂ snow, etc.; (2) wet methods, including the so-called RCA clean process (developed by RCA for use in cleaning semiconductor substrates), wet stripping with liquid chemicals such as, for example, sulfuric acid, hydrochloric acid, hydrogen peroxide, piranha etch (a mixture of sulfuric acid and hydrogen peroxide), ozonated deionized water (DI water), and ammonium hydroxide solutions, and the use of organic solvents, for example, various choline solutions, amine-based solutions, M-pyrrole, paint removers, etc.; and (3) a combination of both dry and wet methods, often in repeating sequences.

Dry methods often involve the use of a plasma of high-energy ions to remove organic materials (dry-ashing, or plasma ashing). There are two general categories of plasma methods employed. One of the plasma methods, often referred to as barrel-ashing, makes use of a stream of plasma directed at the substrate. The other method, often referred to as down-stream ashing, involves the use of a plasma gas atmosphere "downstream" (i.e. physically distant from) from the source of the plasma so as to minimize the damage to the substrate. Different plasma gases may be used, including those made up of various mixes of oxygen, ozone, and nitrogen gas, creating CO, CO₂ and H₂O as end products (see, e.g., Silicon Processing for the VLSI Era, Volume 1 - Process Technology, S. Wolf and R.N. Tauber, p 564, Lattice Press, Sunset Beach, California, 1986).

In some cases, a hydrogen plasma may be required to assist the dry process. For example, for very difficult-to-remove photoresists, hydrogen plasma may be used to strip the upper layer of hardened resist to create easy-to-strip hydrides (see, e.g. "Choose the Right Process to Strip Your Photoresist", Semiconductor International, February 1990, p. 83). In other cases, difficult-to-remove residues may require the addition of fluorine gas, or some other halogen gas, to the plasma gas mix, or even a follow-up exposure to hydrofluoric acid vapor (see, e.g. "Managing Etch and Implant Residue", Semiconductor International, August 1997, p. 62).

Several drawbacks are associated with plasma processes. These include: (1) radiation damage to the underlying substrate, where bombardment of the substrate by high-energy ion plasmas, particularly in the barrel-ashers, can damage the crystal structure of the substrate as well as implant undesired atoms in the substrate, thus reducing yield and reliability of substrate devices (although the damage may be minimized by annealing or by using down-stream ashers which minimize radiation damage at the cost of slower and less effective organic removal rates); (2) creation of additional contamination as high-dose ion plasmas striking impurities in the resist react to form etch-resistant, insoluble inorganic oxides (see, e.g., "New Concerns in Dry Oxygen Ashing", Semiconductor International, March 1996, p. 44); (3) worsening of the existing contamination typically found in commercial photoresists as the high-energy plasma drives existing metal impurities into the substrate; (4) formation of difficult-to-remove residues such as "via veils", and "metal fences" and the hardening of sidewall polymers as the result of the interaction of released by-products of plasma etching with the side-walls in the substrate structure at elevated temperatures; and (5) incomplete removal, cleaning and stripping of the photoresists and other organic materials from very small features due to micro-masking of the resists from further processing by sputtered oxides which may form as a result of high-energy ion impact.

Other dry methods are in use which do not require high-energy plasmas. However, these non-plasma methods suffer in general either from (1) low removal rates, (2) high-temperature processing conditions, (3) excessive damage to the substrate, for example, damage from mechanical abrasion caused by micro-sandblasting techniques such as, for example, cryogenic aerosols, the potential for damage created by temperature fluctuations such as, for example, CO₂ snow methods (see, e.g. "Emerging Technology; Emerging Markets", Precision Cleaning, October 1996, p. 14), and damage created by ultraviolet light exposure (UV-exposure), or (4) an inability to completely remove or strip organic materials which have been hardened by exposure to prior processing such as high temperature, or high energy, high dose, ion-implant.

Wet methods, including, for example, the RCA clean, specialized organic solvents, acids, and oxidizing solutions such as Caro's acid, and other liquid reagents, also have a number of drawbacks when used to remove, clean, or strip organic materials. These drawbacks include: (1) incomplete removal of organic materials due to the difficulty all liquids have in penetrating very small features and in overcoming surface tension and capillary action, (2) incomplete removal due to a limited ability to affect certain organic materials, including photoresists, photoresist residues and organo-metallic complexes which have been hardened by exposure to high energy, high dose ion-implant, or high temperature processing, (3) further introduction of metallic impurities and other residual contamination commonly found in liquid reagents, (4) the spread of contamination to all parts of the substrate, particularly as trace organic residues accumulate in the cleaning solution during the stripping process, (5) the hazardous or toxic nature of many of the organic solvents and acids required, (6) the large volumes of hazardous or toxic reagents which must be maintained in a highly pure condition, often at elevated temperatures, (7) the large number of different types of reagents which must be kept at hand to deal with different cleaning applications and processing conditions, (8) the difficulty and cost of safely disposing of large volumes of hazardous or toxic reagents, and (9) the propensity of many liquid reagents to cause corrosion of the substrate, particularly when metal films are contained in the substrate.

The RCA clean process, a commonly used wet process which involves treatment with NH₄OH/H₂O₂ followed by HCl/H₂O₂, has similar drawbacks which limit its effectiveness and application.

Despite the drawbacks of these various methods for removing, cleaning and stripping organic materials, dry methods in combination with wet methods, sometimes requiring several repetitions, must be used, for lack of better methods, to achieve acceptable levels of cleanliness when removing, cleaning and stripping certain very difficult-to-remove organic materials, particularly hardened photoresists. Hardening of photoresists as the result of prior processing is often a problem, making removal, cleaning and stripping difficult. Hardening of photoresists arises from several sources, including (1) exposure to high energy electromagnetic radiation normally used in photolithographic processes and very short wavelength, or deep UV, photoresist curing steps, (2) high energy, high dose ion-implant processes, (3) reactive ion etching processes (RIE), (4) high temperature processes such as post-bake, photoresist curing steps, (5) oxide, metal or polysilicon dry etching, as well as other physical and chemical treatments. In addition, dry etching and dry-ashing processes often create extremely etch-resistant polymers and residues of inorganic or organo-metallic materials, such as sidewall polymers, via veils and metal fences (see, e.g., "What's Driving Resist Dry Stripping", Semiconductor International, November 1994, p. 61). Under such conditions, wet and dry methods in combination may be the only available technique which can provide satisfactory removal, cleaning and stripping of the organic material. Even under conditions where prior art is used in repeated sequential combinations of dry then wet processing, certain organic materials may still be resistant to satisfactory removal. For example, photoresists exposed to oxide etch processes leave carbon-fluorine polymers which are resistant to removal even with successive applications of dry and wet strip processes followed by an RCA clean.

The prior art thus suffers from numerous drawbacks which may be overcome with this invention. Such drawbacks include: (1) difficulty in removing hardened organic materials, including sidewall polymers, via veils, metal fences and other inorganic residues, and photoresists which may have been exposed to high-energy electromagnetic radiation such as UV-hardening (ultraviolet radiation hardening), or high energy, high dose ion-implant, or reactive ion etch (RIE), (2) difficulty in removing organic materials from very small features (generally sub-micron) and high aspect-ratio features without using substrate-damaging plasma methods, (3) the introduction of substrate damage or film erosion when plasma methods must be employed for lack of an effective alternative, (4) the creation of new, removal-resistant inorganic materials when plasma methods must be employed for lack of an effective alternative, (5) the worsening of existing contamination which may be driven into the substrate when plasma methods must be employed for lack of an effective alternative, (6) the introduction of additional contaminants when liquid reagents and solvents are used, (7) the spread of contamination between substrates when liquid reagent and solvent baths are used, (8) the difficulties and expense of buying, using and disposing of large volumes of hazardous or toxic liquid reagents and solvents, (9) the relative complexity of plasma-based methods which require radio-frequency or microwave generators as well as high-vacuum pumps and systems, (10) the difficulty in maintaining a uniform removal process across the diameter of the substrate when barrel-ashers are used and whenever a stripping process must be stopped by the calculation of an optimum end-point, (11) the relatively high temperature of many dry methods (200°C and up) which can make some diffusion-related problems, such as the diffusion of impurities into the substrate, more severe (both diffusion of impurity materials and consumption of thermal budget may be concerns of the user, depending on the substrate manufacturing process employed), (12) the difficulty of scaling up dry-processes to handle substrate 304,8 mm (12 inches) in diameter and greater, (13) the difficulty of using the prior art when stripping organic materials from metal films without inviting corrosion of that metal film, (14) the poor selectivity of oxygen plasmas to photoresist over certain organic films lying in close proximity (such as the approximate 1:1 selectivity displayed by oxygen plasmas when used to remove photoresist in close proximity to the interlayer dielectric film material, BCB), and (15) the frequent requirement to develop and operate, complex and expensive multi-step, combination dry plus wet, removal processes in order to adequately clean hardened organic materials from substrates.

U.S. Patent 5,037,506, issued August 6, 1991, to S. Gupta et al and entitled "Method of Stripping Layers of Organic Materials", discloses and claims a two-step method using gaseous sulfur trioxide followed by rinsing with a solvent to remove various organic coatings, polymerized photoresist, and especially implant and deep-UV hardened resist layers, during the manufacture of semiconductor or ceramic devices. While the method disclosed or claimed in this patent is useful, there are further needs for cleaning surfaces and removing organic materials which are not disclosed or claimed in this patent and which extend into other areas of technology. Specifically, those undisclosed and unclaimed needs include the need to remove, clean, and strip organic materials contained on a broad range of substrates including not just semiconductor devices, wafers, ceramic devices and printed circuit boards as suggested in the prior art, but also from liquid crystal display devices, photomasks, flat-panel displays, printed wiring boards, magnetic read/write heads, thin-film read/write heads, which also contain features (1) where liquid stripping and cleaning methods are inadequate due to surface tension and capillary effects, or due to the contamination introduced and spread by liquids; (2) where plasma techniques result in substrate damage, erosion, or incomplete removal of the organic material; (3) where there is a requirement for improved uniformity of the removal method across the substrate diameter or large dimension than is provided by the prior art; (4) where there is a requirement for the removal of organic materials at a throughput rate which is faster than that provided by prior art, either with an inherently faster organic removal rate, or by providing for very large, batch processing capability; (5) where there is a requirement for more effective removal of silicon polymers, sidewall polymers, via veils, metal fences, and other inorganic residues created by dry etching processes; (6) where there is a requirement for an integrated method for cleaning both organic and inorganic residues with a minimum use of hazardous or toxic and other liquid wastes; (7) where there is a requirement to minimize or eliminate the corrosion of substrate metal films during organic cleaning, (8) where there is a requirement to integrate steps in the stripping and cleaning process in order to improve cycle time, work-in-process, and throughput, (9) where there is a requirement to minimize processing temperatures, and (10) where there is a requirement to remove or strip only part of the organic coating, film or layer, as may be required, as an example, in efforts to planarize or shape that coating, or to remove one organic coating from an underlying organic coating with significant selectivity.

As a result of the passage of time, it has become clear to the present inventors that there are additional considerations regarding the method of the above-mentioned patent that are required in order to improve the effectiveness of the method. As discussed herein, by effectiveness of the method is meant completeness of the organic removal process, elimination of substrate damage and erosion, improved uniformity of processing across the substrate, faster organic removal rate and substrate throughput, an increase in the number of substrates that can be processed simultaneously during one process cycle, minimization of corrosion of the substrate, minimization of total liquid wastes generated by the method, minimization of hazardous or toxic chemical usage, minimization of total process cycle time, minimization of process temperature requirements, and improved selectivity of removal for one type of organic coating lying in close proximity to a second type of organic coating. These additional considerations include: (1) a precursor chemical or physical treatment of the organic material and the substrate may be required prior to insertion of the substrate into the sulfur trioxide reaction chamber for exposure to the process gases; (2) reactive process gases other than inert gases, dry-nitrogen or sulfur trioxide, as specified in prior art, may also be required to be mixed in the sulfur trioxide reaction chamber with the sulfur trioxide; (3) reactive process gases other than sulfur trioxide may also be required to be introduced to the sulfur trioxide reaction chamber in a specific sequence, either before or after introduction of sulfur trioxide; (4) any one of the process gases may also be required to be replenished in the sulfur trioxide reaction chamber at regular intervals during the method; (5) all of the process gases in the sulfur trioxide reaction chamber may also be required to be in movement, and that movement may be required to be in a specific flow pattern, during the method; (6) while in the sulfur trioxide reaction chamber the temperature of the process gases and the substrate may also be required to follow a temperature-time curve; (7) the partial-pressure of any of the process gases in the sulfur trioxide reaction chamber may also be required to follow a partial-pressure versus time curve; (8) simultaneous physical treatment of the substrate (e.g., exposure to high-energy electromagnetic radiation such as ultraviolet light) may also be required during exposure to the process gases while contained within the exposure chamber; (9) it may be necessary to stop the process reactions within the sulfur trioxide reaction chamber prior to their completion and at a precise moment in time; (10) a pre-rinse chemical or physical treatment of the substrate may also be required after exposure to the process gases within the sulfur trioxide reaction chamber but prior to rinsing in a solution to remove reaction products; (11) application of simultaneous physical processes such as, for example, ultrasonic or megasonic processes, or various other kinetic processes, are required while rinsing the substrate in a solution to remove reaction products as described in prior art; and (12) a post-rinse chemical or physical treatment of the substrate may also be required after rinsing in a solution to remove reaction products.

What is needed is a method which satisfies these considerations for effectively removing, stripping, or cleaning organic coatings, films, layers and residues consisting of, for example, photosensitive and non-photosensitive organic materials, polymerized photoresists, cured and uncured polyimides, polycarbonates, paints, resins, multilayer organic polymers, certain organometallic complexes, positive optical photoresist, negative optical photoresist, chemically amplified photoresists, electron-beam photoresists, x-ray photoresists, ion-beam photoresists, and ion-implanted and other hardened photoresists from a variety of substrates selected from the group consisting of semiconductor devices and wafers, ceramic devices, liquid crystal display devices, photomasks, flat-panel displays, printed circuit boards, printed wiring boards, magnetic read/write heads, thin-film read/write heads.

WO-A-89/00895 discloses a method according to the preamble of claim 1.

U.S. Patent No. 5,763,016 is concerned with forming patterns in the surfaces of organic materials by treating with a vapour comprising sulfur trioxide.

### SUMMARY OF THE INVENTION

Accordingly, it is an object of this invention to provide a method for complete removal, cleaning and stripping of organic coatings, films, layers and residues consisting of, for example, photosensitive and non-photosensitive organic materials, polymerized photoresists, cured and uncured polyimides, polycarbonates, paints, resins, multilayer organic polymers, certain organometallic complexes, positive optical photoresist, negative optical photoresist, chemically amplified photoresists, electron-beam photoresists, x-ray photoresists, ion-beam photoresists, and ion-implanted and other hardened photoresists from a variety of substrates selected from the group consisting of semiconductor devices and wafers, ceramic devices, liquid crystal display devices, photomasks, flat-panel displays, printed circuit boards, printed wiring boards, magnetic read/write heads, thin-film read/write heads, which:
(1) does not make use of liquid stripping or cleaning reagents, including, as examples, organic and inorganic solvents and acids,
(2) does not make use of plasma processes, including, as examples, dry-ashing, barrel ashing, or down-stream ashing,
(3) is effective for completely removing, cleaning, or stripping some organic materials at process temperatures below 200°C,
(4) provides better uniformity of removal, clean, or strip across the substrate than can be provided by plasma stripping or cleaning processes which require end-point detection to determine an optimum time to stop the process,
(5) provides better uniformity of removal, clean, or strip between individually processed substrates than can be provided by plasma stripping or cleaning processes which require end-point detection to determine an optimum time to stop the process,
(6) provides improved selectivity of removal between organic films of two different types which may be in close proximity, such as in the case of organic photoresist and organic interlayer dielectric films, and
(7) may be embodied, effectively, as part of an integrated cleaning process for cleaning and removing inorganic materials as well as organic materials.

In accordance with the present invention, a method is provided for completely removing organic coatings, films, layers or residues from a substrate, wherein said substrate is selected from the group consisting of semiconductor devices and wafers, ceramic devices, liquid crystal display devices, flat-panel displays, printed circuit boards, magnetic read/write heads, thin-film read/write heads. The method comprises:
(1) subjecting said organic coatings, films, layers, or residues to a vapor treatment step for a period of time, said substrates being maintained at a temperature in the range from room temperature to 400°C; and
(2) subjecting said organic coatings, films, layers, or residues to a solvent rinse;
   (a) providing said substrates having said organic coatings, films, layers and residues thereon;
   (b) subjecting said organic coatings, films, layers, or residues of step (a) to a precursor chemical or physical treatment prior to step (1) so as to facilitate reaction of the vapor in step (c) below with said organic coatings, films, layers or residues to be removed;
   (c) carrying out said step (1) so that said vapor reacts with said organic coatings, films, layers and residues to form physically or chemically altered organic material;
   (d) carrying out said step (2) to remove said altered organic material from said substrates; and
   (e) subjecting said organic coatings, films, layers, or residues to a chemical or physical post-rinse treatment subsequent to step (2) so as to remove any residual organic material from said substrates remaining after said solvent rinse;
   characterized in that the vapor treatment step consists essentially of treatment with water-free gaseous sulfur trioxide.

The sulfur trioxide, which acts as a removal, cleaning, and stripping agent, oxidizes, sulfonates, sulfates, sulfamates, or otherwise reacts, to cause all types of organic coatings, films, layers and residues consisting of, for example, photosensitive and non-photosensitive organic materials, polymerized photoresists, cured and uncured polyimides, polycarbonates, paints, resins, multilayer organic polymers, certain organo-metallic complexes, positive optical photoresist, negative optical photoresist, chemically amplified photoresists, electron-beam photoresists, X-ray photoresists, ion-beam photoresists, and ion-implanted and other hardened photoresists to be substantially completely removable by subsequent chemical or physical treatment.

After preparing the sulfur trioxide reaction chamber for use by first flushing it with inert gases, substrates upon which organic coatings, films, layers and residues have been deposited, regardless of the method of deposition, are exposed to regulated quantities of gaseous sulfur trioxide and other process gases. These gases are dispensed into chambers, or a series of closed chambers with good vacuum integrity, which contain the substrates. Additional chemical and physical treatments are employed prior to, during, and subsequent to exposure to these process gases for the purpose of improving the effectiveness of the method. Liquid or solid sulfur trioxide, whether in alpha, beta, or gamma form, or a mixture thereof, may be stored and used as the source of vapor. Sulfur trioxide is an extremely strong oxidizing and sulfonating chemical, and is very effective as an agent in removing, cleaning and stripping a variety of organic materials. Sulfur trioxide gas is particularly effective as an agent in removing, cleaning and stripping organic materials such as plasma-hardened photoresists, carbon-fluorine containing polymers, UV-hardened photoresists, and side-wall polymers from sub-micrometer grooves and crevices. Being in a gas phase, sulfur trioxide achieves a more thorough contact with the surfaces of sub-micrometer grooves and crevices than is possible by liquid solutions.

The present invention for removing, cleaning, or stripping a wide variety of organic materials which may be deposited or formed on substrates during the manufacture, repair or rework of those substrates may be carried out over a temperature range which is unlimited with regard to the effectiveness of the method. However, some embodiments of this invention require a temperature range between room temperature and 400°C for optimum effectiveness for specific materials and substrates.

Examples of some substrate materials which may be beneficially treated in accordance with the present invention include materials specifically used in the manufacture and repair of semiconductor wafers and devices, such as silicon, polysilicon, germanium, III-V compound semiconductors (e.g. gallium arsenide), oxides (both crystalline and glassy), nitrides, oxynitrides, organic films, organic dielectrics (e.g. polyimides, benzocyclobutene), organo-metallic complexes and polymers, metals and metal alloys.

Additional examples of substrate materials which may be beneficially treated in accordance with the present invention include materials such as glass, polycarbonates, and cured and uncured polyimides.

The use of a sulfur trioxide, organic removal, cleaning and stripping method as described in this invention provides for more efficient, more effective, and more environmentally benign processing of semiconductor devices and wafers, ceramic devices, liquid crystal display devices, photomasks, flat-panel displays, printed circuit boards, printed wiring boards, magnetic read/write heads, thin-film read/write heads, which contain very small features, than is available using prior art.

### BRIEF DESCRIPTION OF THE DRAWINGS

The sole Figure depicts a flow chart of the method of the present invention.

### DETAILED DESCRIPTION OF THE INVENTION

Details of a specific embodiment of the present invention are described to illustrate the best mode presently contemplated by the inventors for practicing the invention. Alternative embodiments are also briefly described as applicable.

A method has been designed and developed to remove, clean or strip organic coatings, films, layers and residues consisting of, for example, photosensitive and non-photosensitive organic materials, polymerized photoresists, cured and uncured polyimides, polycarbonates, paints, resins, multilayer organic polymers, certain organo-metallic complexes, positive optical photoresist, negative optical photoresist, chemically amplified photoresists, electron-beam photoresists, X-ray photoresists, ion-beam photoresists, and ion-implanted and other hardened photoresists that may have been deposited by design, or as a result of intended or unintended chemical and physical processes needed for manufacture and repair, on semiconductor devices and wafers, ceramic devices, liquid crystal display devices, photomasks, flat-panel displays, printed circuit boards, printed wiring boards, magnetic read/write heads, thin-film read/write heads. It is an important feature of this invention that, unlike dry and wet stripping and cleaning methods described in prior art, this method can completely remove, clean and strip hardened photoresist coatings and residues, such as polymerized photoresists, ion-implanted and deep-UV hardened photoresist layers, side-wall polymers, metal fences, via veils, and other photoresist residues without damaging the underlying substrates and without using hazardous or toxic liquid chemicals.

The basic concept behind this invention is that a novel chemical agent, under the correct processing conditions, and when used in conjunction with the correct physical and chemical treatments applied at the correct time during the process, and comprising essentially of sulfur trioxide, is used in gaseous form to oxidize, sulfonate, sulfate, sulfamate, or otherwise react with a wide variety of organic materials which may be deposited or formed on substrates during the manufacture, repair or rework of those substrates so as to cause the desired organic materials to be substantially removed, cleaned, or stripped from the surface of the substrate. Sulfur trioxide, being a highly reactive agent, is very effective when used in removing, cleaning and stripping a variety of hardened organic materials. The gaseous form of sulfur trioxide, coupled with its reactive power, is also an agent which provides for very effective removal, cleaning and stripping of a variety of organic materials from sub-micrometer grooves and crevices of exposed substrates. Being in a gas phase, sulfur trioxide does not suffer from the surface tension and capillary-action effects that limit the action of liquid solutions by preventing contact with the walls of such grooves and crevices. The present invention thus provides (1) a method for applying an extremely powerful reactive agent to very small grooves and crevices not easily accessible by liquid agents, so as to cause organic coatings, films, layers and residues to be substantially removed, cleaned or stripped from those grooves and crevices; (2) a method for removing, cleaning and stripping organic coatings, films, layers and residues without the use of large volumes of hazardous or toxic solvents and reagents; (3) a method for removing, cleaning and stripping organic coatings, films, layers and residues which is effective at between room temperature and 200°C; (4) a method for removing, cleaning and stripping organic coatings, films, layers and residues which is easily integrated into inorganic cleaning and stripping processes; (5) a method for partially or completely removing organic coatings, films and layers uniformly across the substrate; (6) a method for selectively, and completely, removing organic coatings, films and layers without damaging certain organic coatings of a different type which may lie in close proximity; and (7) a method for partially or completely removing organic coatings, films and layers uniformly between individually processed substrates.

In the method of the invention, sulfur trioxide, which may be in alpha form, beta form, gamma form or a mixture thereof, is stored and used as the primary oxidizing, sulfonating, sulfating, sulfonating and otherwise reactive agent. Gamma-sulfur trioxide, with a melting point of 16.8°C, is the preferred form for sulfur trioxide to be used in the invention, and is the form in which SO₃ exists when it is maintained in absolutely pure and anhydrous condition. In general, stabilized gamma-sulfur trioxide is used, where addition of a small quantity of inhibitor (stabilizer) prevents formation of the high melting-point beta (32.5°C) and alpha (62.3°C) forms. Gamma-sulfur trioxide is commercially available with such inhibitors. The stabilized sulfur trioxide can readily be remelted, if it is allowed to solidify. Both stabilized and unstabilized sulfur trioxide may be used in the method of this invention. Water-free, gaseous sulfur trioxide is employed in the removal of the organic coatings, films, layers and residues. It is an important requirement of this method, to eliminate or minimize the introduction of water or water vapor to the sulfur trioxide gas at the correct time in the method, and to control the water content during the course of the method. To the extent that water is present during the exposure to the sulfur trioxide gas, the effectiveness of the process decreases.

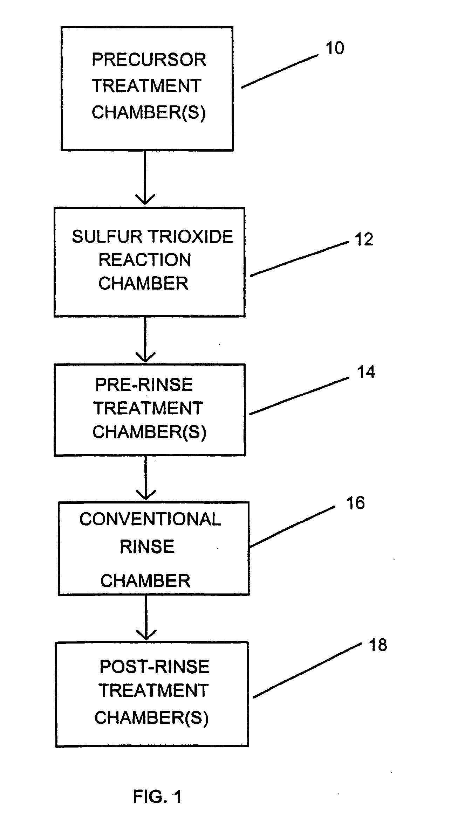

The removal, cleaning and stripping method of the invention is advantageously embodied in both batch (multiple substrates) and single-substrate operation modes in a method illustrated by the flow chart shown in FIG. 1. The method comprises several steps where the substrate containing the organic coating, film, layer or residue to be removed is first treated with a precursor physical or chemical treatment in one or more chambers in Step 10 to prepare it for exposure to gaseous sulfur trioxide so as to facilitate the reaction of the sulfur trioxide with the organic material to be removed. Precursor physical or chemical treatments include, for example, physical treatments with heat, high-energy electromagnetic radiation, such as infrared radiation (IR), ultra-violet light radiation (UV), or laser energy; or chemical treatments with reactive and non-reactive gases or liquids, including, for example, oxygen, nitrous oxide, steam, vapor phase hydrogen peroxide, nitrogen, or various solvents.

After completion of the appropriate precursor Step 10, the substrate is then placed in the sulfur trioxide reaction chamber in Step 12 for exposure to a vapor consisting essentially of water-free gaseous sulfur trioxide. In some embodiments of this invention, it is convenient to conduct the precursor step (1) and the sulfur trioxide exposure step (2) within the same physical reaction chamber. In other embodiments, several chambers may be required for these two steps. In any case, during the sulfur trioxide exposure step, and as described in prior art, regulated quantities of gaseous sulfur trioxide are dispensed, continuously or at appropriate intervals, into closed, vacuum-sealed chamber(s), which are required primarily to minimize and control the moisture level during sulfur trioxide exposure. Moisture level may also be minimized and controlled by maintaining the walls of the chamber(s) at elevated temperatures. The flow rate and pressure of sulfur trioxide gas and other process gases, and the time of exposure needed for the sulfur trioxide exposure step in the method will depend on the size of chamber(s) and the quantities of substrates, and their sizes, to be subjected to the exposure at one time. After introduction of the substrate to be cleaned or stripped into the chamber, the chamber is purged, one or several times, with a dry inert gas, such as nitrogen or one of the commonly used inert gases. The chamber is then evacuated to a suitable vacuum, such as on the order of about 1.33 x 10⁻⁶ bar (10⁻³ Torr). Water-free, gaseous sulfur trioxide is then introduced into the chamber as a reactive agent for removing, cleaning or stripping the organic coatings, films, layers and residues contained on the substrates. While the time of exposure of the substrate to the gaseous sulfur trioxide and other process gases varies depending on several factors, as indicated above, the typical time of exposure is less than five minutes. Depending upon the nature of the organic material to be removed, cleaned or stripped, the number of substrates in the sulfur trioxide reaction chamber, the size of each substrate, and other processing conditions, longer times or repeated exposures may be needed. However, the determination of the time for a particular organic material, substrate, and set of processing conditions is easily done, and constitutes no undue experimentation. The substrate may be maintained at room temperature during exposure to the gaseous sulfur trioxide or heated to an elevated temperature. If heated, the temperature is not a limitation of the method. Temperature of the substrate and the processing environment is controlled, and may be limited, in order to in order to improve the effectiveness of the method. Typically, the temperature range is between room temperature and 400°C. As used herein, the term "room temperature" refers to the ambient temperature of the facility in which the process is being carried out, and is typically in the range of about 23° to 25°C.

During the sulfur trioxide exposure step, although undisclosed by prior art, it may be necessary to apply one or more simultaneous physical or chemical treatments while the substrate resides within the sulfur trioxide reaction chamber. Simultaneous physical or chemical treatments include, for example, physical treatments with high-energy electromagnetic radiation, such as infrared radiation, UV radiation, laser energy; directional flow of the process gases through the chamber by means of the physical design of the sulfur trioxide reaction chamber; or chemical treatments by means of the introduction of reactive gases in addition to sulfur trioxide and nitrogen, such as vaporized solvents or nitrous oxide, in order to improve the effectiveness of the method. In the preferred embodiment of this invention, simultaneous treatments are not precisely coincident with the presence of sulfur trioxide gas within the sulfur trioxide reaction chamber. The required timing for each of the simultaneous physical or chemical treatments within the sulfur trioxide reaction chamber depends on the nature of the organic material and the set of prior processing conditions experienced by the organic material.

After completion of the sulfur trioxide exposure step, the substrate may optionally be treated to one or more pre-rinse physical or chemical treatments in one or more chambers, as shown in Step 14, to facilitate the removal of the reacted and unreacted organic material which remains on the substrate after the sulfur trioxide exposure step. Pre-rinse physical or chemical treatments include, for example, physical treatments with heat, high-pressure de-ionized water (DI water) sprays, treatment with sound energy such as megasonic or ultrasonic treatments, exposure to laser energy, or kinetic treatments such as physical scrubbing, or exposure to a CO₂ snow process; or chemical treatments with various reactive gases such as oxygen, nitrous oxide, steam, and vapor phase hydrogen peroxide, or solutions or solvents, including for example, various acidic or alkaline solutions or amine-based solutions.

After completion of the optional, appropriate pre-rinse physical or chemical treatment Step 14, the substrate is then processed through one of the conventional, or standard, rinse treatments in chamber, as shown in Step 16, as described in the prior art. Such rinse comprises use of a rinse solvent, such as water, a lower alkanol (1 to 5 carbon atoms), acetone, or mixtures thereof, various acidic or alkaline solutions or amine-based solutions. During the rinse treatment of Step 16, the substrate may be subjected to one or more physical treatments, such as heat, high-pressure de-ionized water (DI water) sprays, treatment with sound energy such as megasonic or ultrasonic treatments or exposure to laser energy. After completion of the conventional rinse treatment of Step 16, the substrate is next treated with one or more post-rinse physical or chemical treatments in one or more chambers, as shown in Step 18, to further facilitate the removal of any residual organic material which remains on the surface of the substrate after the standard rinse step. Post-rinse physical or chemical treatments include, for example, physical treatments with heat, high-energy electromagnetic radiation, such as infrared radiation (IR), ultra-violet light radiation (UV), or laser energy, high-pressure DI-water sprays, treatment with sound energy such as megasonic or ultrasonic treatments, exposure to laser energy, or kinetic treatments such as physical scrubbing, or exposure to a CO₂ snow process; or chemical treatments with various reactive gases such as oxygen, nitrous oxide, steam, and vapor phase hydrogen peroxide, or solutions or solvents, including for example, various acidic or alkaline solutions commonly employed in photoresist stripping, choline, or amine-based solutions employed in photoresist stripping.

If employed in any of the treatment steps, high-pressure DI water sprays are performed with deionized water under pressure of about 24.13 to 172.38 bar (350 to 2,500 psi) preferably about 82.74 bar (1,200 psi), employing either a fan nozzle or a jewel-tip nozzle. The water may be cooled or heated, if desired, within the range of just above freezing to just below boiling.

The method of the present invention has no deleterious effect on the surface of many of the inorganic substrate or on the inorganic coatings thereon. For example, surface oxides, such as silicon oxide and oxide glasses, nitrides, oxynitrides, many metals, silicides, silicon, polysilicon, and the like are unaffected by the process.

Without subscribing to a particular theory and independent of the details of the sulfur trioxide reactions, the underlying principle of the operation in the invention is the exhaustive oxidation, sulfonation, sulfation, sulfamation, or other chemical reaction with the organic coatings, films, layers and residues which is made possible by the access of sulfur trioxide vapor to all parts of the substrate surface, including grooves, crevices and all sub-micrometer structures thereon, in conjunction with the correct physical and chemical treatments applied at the appropriate time during the process. The method of the invention can be carried out whether sulfur trioxide is used in the form of pure or stabilized gas, or vaporized from a pure or stabilized liquid, or solid, sulfur trioxide source. The method of the invention equally applies when the reactivity of the sulfur trioxide vapor is obtained from a mixture of chemical substances, in gaseous, liquid, or solid form, with the net effect of producing sulfur trioxide vapor, in pure form or otherwise, at the rate and quantity needed to carry out specific removal, cleaning or stripping reactions.

In certain embodiments of the present invention, complete reaction of the organic coatings, films, layers and residues with the process gases, including sulfur trioxide, occurs rapidly from surfaces of substrates including, as examples, semiconductor wafers and devices, such as silicon, polysilicon, germanium, III-V compound semiconductors (e.g. gallium arsenide), oxides (both crystalline and glassy), nitrides, oxynitrides, organic films, organic dielectrics (e.g. polyimides, benzocyclobutene), organo-metallic complexes and polymers, metals and metal alloys.

In certain other embodiments of the present invention, not described in the prior art, incomplete reaction may be desired during the sulfur trioxide exposure step, as in the case when the substrate contains an organic coating, film, or layer to be only partially removed or stripped from the substrate. In such embodiments, various physical or chemical mechanisms are required to cause cessation of the reaction with the process gases at the appropriate time (which may be identified, for example, with an end-point detector). Examples of appropriate mechanisms for halting or slowing the reaction include (1) application of chemical processes, such as the replacement of the highly reactive process gases with less reactive gases, (2) application of physical processes which affect the reaction, such as electromagnetic radiation including infrared, ultra-violet light radiation (UV), and higher energy wave lengths, (3) application of heat to the substrate so as to change the thermal characteristics of the substrate, (4) withdrawal of the substrate from the sulfur trioxide reaction chamber, and (5) replacement of the reactive process gases with inert gases.

In general, the method of the present invention has the capability to remove, clean or strip organic coatings, films, layers and residues with different histories of prior physical and chemical processing including exposure to electromagnetic radiation of various wavelengths including ultra-violet light radiation (UV), exposure to plasma treatment, and exposure to chemical processes which may change the properties of the organic material. In particular, resists and polymers which are exposed to deep-UV, ion-implant, reactive ion etch (RIE), dry and wet etching, and other harsh plasma treatments can readily and efficiently be removed, cleaned or stripped by means of the reaction with sulfur trioxide gas.

The method of the present invention remains equally effective when sub-micrometer structural features are added to the substrate.

The chemical and physical properties of the organic coatings, films, layers and residues, as well as the method of deposition on the substrate is not critical to the method of the present invention. The organic coatings, films, layers and residues may include, for example, aromatic and aliphatic resists, deposited unintentionally by prior processing activities or intentionally by any organic coating method including roller application, dipping, brushing, spraying, the use of sheets of dry resist, spin-on, electrophoresis, plasma deposition, chemical vapor deposition and other techniques for applying organic coatings, films and layers.

Examples of specific removal, cleaning and stripping applications include applications to organic polymer removal, for example, photoresist stripping, BCB (benzocyclobutene) stripping, post-plasma etch cleaning (for example, via cleaning, contact cleaning), stringer polymer removal, metal fence and via veil residue cleaning, silicon polymer removal, cured and uncured polyimide stripping, and polycarbonate stripping. Side-wall polymers, silicon polymers, stringer polymers, via veils and metal fences are those complex polymers formed typically, but not exclusively, during reactive ion etch (RIE). Difficulty in cleaning these polymers and residues is a notable drawback of the prior art which can be overcome with the method of this invention. These polymers may contain metals, metal oxides, etchants, and other inorganic by-products of the RIE which make them difficult to remove solely with prior art such as that describing oxygen-based plasma processes (for example, dry-ashing), or such as that describing only a sulfur trioxide exposure step followed by a standard rinse step. These polymers are amenable to removal, cleaning and stripping with the method of this invention. Failure to adequately remove these materials can lead to contamination which has negative impact on device yields and reliability.

Other examples of specific removal, cleaning and stripping applications, include application to stripping organic coatings, films, or layers from a variety of substrates which includes, semiconductor devices and wafers, ceramic devices, liquid crystal display devices, photomasks, flat-panel displays, printed circuit boards, printed wiring boards, magnetic read/write heads, thin-film read/write heads, as well as other substrates upon which organic films may have been deposited.

Examples of organic coatings, films or layers which may be beneficially treated in accordance with the present invention include organic dielectrics. Such organic dielectrics include polyimides, copolyimides, polyamides, polyamide-imdes, fluorinated polyimides, poly(arylenethers), fluorinated poly(arylenethers), perfluorinated alkylene oxides, parylene (N, C, D, or F type), poly(phenylquinoxalines), polynaphthalene, poly-fluorinated naphthalene, benzocyclobutene (BCB), amorphous fluoropolymers, such as polytetrafluoroethylene, perfluorocyclobutane aromatic ether (PFCB), polynorbornene, and fluorinated carbon.

Thus, there has been disclosed a process for removal, cleaning and stripping, organic coatings, films, layers and residues from various types of surfaces. It will be readily apparent to those skilled in this art that various changes and modifications of an obvious nature may be made, and all such changes and modifications are considered to fall within the scope of the claims as defined by the appended claims.

## Claims

1. A method for completely removing organic coatings, films, layers or residues from a substrate, wherein said substrate is selected from the group consisting of semiconductor devices and wafers, ceramic devices, liquid crystal display devices, flat-panel displays, printed circuit boards, magnetic read/write heads, thin-film read/write heads, said method comprising:
(1) subjecting said organic coatings, films, layers, or residues to a vapor treatment step for a period of time, said substrates being maintained at a temperature in the range from room temperature to 400°C;
(2) subjecting said organic coatings, films, layers, or residues to a solvent rinse;
(a) providing said substrates having said organic coatings, films, layers and residues thereon;
(b) subjecting said organic coatings, films, layers, or residues of step (a) to a precursor chemical or physical treatment prior to step (1) so as to facilitate reaction of the vapor in step (c) below with said organic coatings, films, layers, or residues to be removed;
(c) carrying out said step (1) so that said vapor reacts with said organic coatings, films, layers, or residues to form a physically or chemically altered organic material;
(d) carrying out said step (2) to remove said altered organic material from said substrates; and
(e) subjecting said organic coatings, films, layers, or residues to a chemical or physical post-rinse treatment subsequent to step (2) so as to remove any residual organic material from said substrates remaining after said solvent rinse;
**characterised in that** the vapor treatment step consists essentially of treatment with water-free gaseous sulfur trioxide.

2. The method of Claim 1 wherein said substrate is selected from the group consisting of Group IV elements, III-V compound semiconductors, oxides, nitrides, oxynitrides, organic films, organic dielectrics, organo-metallic complexes and polymers, metals, and metal alloys.

3. The method of Claim 1 or Claim 2 further including:
(a) treating said substrate to said precursor chemical or precursor physical treatment;
(b) placing said substrate in a chamber;
(c) purging said chamber with a dry inert gas;
(d) introducing said vapor consisting essentially of water-free gaseous sulfur trioxide into said chamber to react with said coating, film, layer, or residue;
(e) allowing a period of time to pass to permit reaction between said sulfur trioxide and said coating; and
(f) ending said reaction between said sulfur trioxide and said coating by subjecting said substrate to an end-point chemical or end-point physical treatment.

4. The method of any preceding Claim wherein (1) said precursor chemical treatment is selected from the group consisting of exposure to chemically active process gases, chemically inert process gases, and solvents, (2) said precursor physical treatment is selected from the group consisting of exposure to heat, electromagnetic radiation of a wavelength including ultra-violet light radiation, laser energy, ultrasonic and megasonic sound energy, and (3) said precursor chemical or physical treatment is carried out at a temperature between room temperature and 400°C.

5. The method of any preceding Claim wherein said solvent rinse is performed in a solvent selected from the group consisting of water, lower alkanols, acetone, acids, bases, choline, amine-based solutions, and mixtures thereof.

6. The method of any preceding Claim wherein said solvent rinse is simultaneously carried out in the presence of megasonic or ultrasonic energy, heat, electromagnetic radiation of a wavelength including ultra-violet light radiation, or laser energy.

7. The method of any preceding Claim wherein (1) said post-rinse chemical treatment is selected from the group consisting of further exposure to chemically active process gases or vapors, chemically inert process gases, and solvents, (2) said post-rinse physical treatment is selected from the group consisting of further exposure to heat, electromagnetic radiation of a wavelength including ultra-violet light radiation, laser energy, kinetic energy, pressurised deionized water sprays, physical scrubbing, CO₂ snow processing, ultrasonic and megasonic sound energy, and (3) said post-rinse chemical or physical treatment is carried out at a temperature between room temperature and 400°C.

8. The method of any preceding Claim wherein step (b) further includes simultaneous exposure to chemical or physical treatment selected from the group consisting of other chemically active process gases and vapors, chemically inert process gases, vaporized solvents, heat, electromagnetic radiation of a wavelength including ultraviolet light radiation, and laser energy.

9. The method of any preceding Claim wherein each said subjecting step is independently performed for a period of time up to 5 minutes.

10. The method of any preceding Claim wherein said organic coatings, films, layers and residues are selected from the group consisting of photosensitive and nonphotosensitive organic materials, polymerized photoresists, paints, resins, single and multilayer organic polymers, certain organo-metallic complexes, positive optical photoresist, negative optical photoresist, electron-beam photoresists, X-ray photoresists, ion-beam photoresists, ion-implanted photoresists, and other hardened photoresists.

11. The method of any preceding Claim further comprising: subjecting said organic coatings, films, layers or residues to a pre-rinse chemical or physical treatment subsequent to step (b).

## Patentansprüche

1. Verfahren zum vollständigen Entfernen von organischen Beschichtungen, Filmen, Schichten oder Rückständen von einem Substrat, wobei das Substrat aus der Gruppe, bestehend aus Halbleitervorrichtungen und -wafern, keramischen Vorrichtungen, Flüssigkristall-Anzeigevorrichtungen, Flachbildschirmen, Leiterplatten, magnetischen Schreib-/Leseköpfen, Dünnschicht-Schreib-/Leseköpfen, ausgewählt ist, wobei das Verfahren umfaßt:
(1) das Unterwerfen der organischen Beschichtungen, Filme, Schichten oder Rückstände einem Dampfbehandlungsschritt für eine Zeitdauer, wobei die Substrate bei einer Temperatur in dem Bereich von Raumtemperatur bis 400°C gehalten werden,
(2) das Unterwerfen der organischen Beschichtungen, Filme, Schichten oder Rückstände einem Lösungsmittelspülen,
(a) das Bereitstellen der Substrate mit den organischen Beschichtungen, Filmen, Schichten und Rückständen darauf,
(b) das Unterwerfen der organischen Beschichtungen, Filme, Schichten oder Rückstände aus Schritt (a) einer chemischen oder physikalischen Vorläuferbehandlung vor dem Schritt (1), um so die Reaktion des Dampfes im nachfolgenden Schritt (c) mit den zu entfernenden organischen Beschichtungen, Filmen, Schichten oder Rückständen zu erleichtern,
(c) das Durchführen des Schrittes (1), so daß der Dampf mit den organischen Beschichtungen, Filmen, Schichten oder Rückständen reagiert, um ein physikalisch oder chemisch verändertes organisches Material zu bilden,
(d) das Durchführen des Schrittes (2), um das veränderte organische Material von dem Substrat zu entfernen, und
(e) das Unterwerfen der organischen Beschichtungen, Filme, Schichten oder Rückstände einer chemischen oder physikalischen Nachspülbehandlung nach dem Schritt (2), um so jedweden nach dem Lösungsmittelspülen verbliebenen organischen Materialrückstand von den Substraten zu entfernen,
**dadurch gekennzeichnet, daß** der Dampfbehandlungsschritt im wesentlichen aus der Behandlung mit wasserfreiem, gasförmigen Schwefeltrioxid besteht.

2. Verfahren nach Anspruch 1, wobei das Substrat aus der Gruppe, bestehend aus Elementen der Gruppe IV, Halbleitern von III-V-Verbindungen, Oxiden, Nitriden, Oxynitriden, organischen Filmen, organischen Dielektrika, organometallischen Komplexen und Polymeren, Metallen und Metalllegierungen, ausgewählt ist.

3. Verfahren nach Anspruch 1 oder Anspruch 2, weiter einschließend:
(a) das Behandeln des Substrats mit der chemischen Vorläufer- oder physikalischen Vorläuferbehandlung,
(b) das Anordnen des Substrats in einer Kammer,
(c) das Spülen der Kammer mit einem trockenen Inertgas,
(d) das Einführen des Dampfes, welcher im wesentlichen aus wasserfreiem, gasförmigem Schwefeltrioxid besteht, in die Kammer, um mit der Beschichtung, dem Film, der Schicht oder dem Rückstand zu reagieren,
(e) das Erlauben des Ablaufens einer Zeitdauer, um die Reaktion zwischen dem Schwefeltrioxid und der Beschichtung zu erlauben, und
(f) das Beenden der Reaktion zwischen dem Schwefeltrioxid und der Beschichtung durch Unterwerfen des Substrates einer chemischen Endpunkt- oder physikalischen Endpunkt-Behandlung.

4. Verfahren nach einem vorstehenden Anspruch, wobei (1) die chemische Vorläuferbehandlung aus der Gruppe, bestehend aus Aussetzen einem chemisch aktivem Prozeßgas, einem chemisch inerten Prozeßgas und Lösungsmitteln, ausgewählt ist, (2) die physikalische Vorläuferbehandlung aus der Gruppe, bestehend aus Aussetzen von Wärme, elektromagnetischer Strahlung einer Wellenlänge, einschließend Strahlung von ultraviolettem Licht, Laserenergie, Ultraschall- und Megaschall-Energie, ausgewählt ist, und (3) die chemische oder physikalische Vorläuferbehandlung bei einer Temperatur zwischen Raumtemperatur und 400°C durchgeführt wird.

5. Verfahren nach einem vorstehenden Anspruch, wobei das Lösungsmittelspülen in einem Lösungsmittel, ausgewählt aus der Gruppe, bestehend aus Wasser, Niederalkanolen, Aceton, Säuren, Basen, Cholin, Lösungen auf Aminbasis und Gemischen davon, durchgeführt wird.

6. Verfahren nach einem vorstehenden Anspruch, wobei das Lösungsmittelspülen gleichzeitig in der Gegenwart von Megaschall- oder Ultraschallenergie, Wärme, elektromagnetischer Strahlung einer Wellenlänge, einschließend Strahlung von ultraviolettem Licht, oder Laserenergie, durchgeführt wird.

7. Verfahren nach einem vorstehenden Anspruch, wobei (1) die chemische Nachspülbehandlung aus der Gruppe, bestehend aus weiterem Aussetzen chemisch aktiven Prozeßgasen oder -dämpfen, chemisch inerten Prozeßgasen und Lösungsmitteln, ausgewählt ist, (2) die physikalische Nachspülbehandlung aus der Gruppe, bestehend aus weiterem Aussetzen von Wärme, elektromagnetischer Strahlung einer Wellenlänge, einschließend Strahlung von ultraviolettem Licht, Laserenergie, kinetischer Energie, unter Druck gesetzten Sprays von entionisiertem Wasser, physikalischem Reinigen, CO₂-Schneeverarbeiten, Ultraschall- und Megaschallenergie, ausgewählt ist, und (3) die chemische oder physikalische Nachspülbehandlung bei einer Temperatur zwischen Raumtemperatur und 400°C durchgeführt wird.

8. Verfahren nach einem vorstehenden Anspruch, wobei Schritt (b) weiter das gleichzeitige Aussetzen einer chemischen oder physikalischen Behandlung, ausgewählt aus der Gruppe, bestehend aus anderen chemisch aktiven Prozeßgasen und -dämpfen, chemisch inerten Prozeßgasen, verdampften Lösungsmitteln, Wärme, elektromagnetischer Strahlung einer Wellenlänge, einschließend Strahlung von ultraviolettem Licht, und Laserenergie, einschließt.

9. Verfahren nach einem vorstehenden Anspruch, wobei jeder Unterwerfungsschritt unabhängig für eine Zeitdauer von bis zu 5 Minuten durchgeführt wird.

10. Verfahren nach einem vorstehenden Anspruch, wobei die organischen Beschichtungen, Filme, Schichten und Rückstände aus der Gruppe, bestehend aus lichtempfindlichen und nicht-lichtempfindlichen organischen Materialien, polymerisierten Photoresists, Anstrichen, Harzen, ein- und mehrschichtigen organischen Polymeren, bestimmten organometallischen Komplexen, positiven optischen Photoresists, negativen optischen Photoresists, Elektronstrahl-Photoresists, Röntgenstrahl-Photoresists, lonenstrahl-Photoresists, lonenimplantierten und anderen gehärteten Photoresists, ausgewählt sind.

11. Verfahren nach einem vorstehenden Anspruch, weiter umfassend das Unterwerfen der organischen Beschichtungen, Filme, Schichten oder Rückstände einer chemischen oder physikalischen Vorspülbehandlung nach Schritt (b).

## Revendications

1. Procédé d'élimination complète de revêtements, films, couches ou résidus organiques d'un substrat, dans lequel ledit substrat est sélectionné dans le groupe constitué par des dispositifs et des tranches semi-conducteurs, des dispositifs céramiques, des écrans à cristaux liquides, des écrans plats, des cartes de circuit imprimé, des tête de lecture/d'écriture magnétiques, des têtes de lecture/d'écriture à couche mince, ledit procédé comprenant les étapes consistant à :
(1) soumettre lesdits revêtements, films, couches ou résidus organiques à une étape de traitement à la vapeur pendant une période de temps, lesdits substrats étant maintenus à une température dans la gamme allant de la température ambiante à 400 °C ;
(2) soumettre lesdits revêtements, films, couches ou résidus organiques à un rinçage au solvant ;
(a) disposer lesdits substrats possédant lesdits revêtements, films, couches ou résidus organiques sur eux-même ;
(b) soumettre lesdits revêtements, films, couches ou résidus organiques de l'étape (a) à un traitement chimique ou physique précurseur avant l'étape (1) de façon à faciliter la réaction de la vapeur dans l'étape (c) ci-après avec lesdits revêtements, films, couches ou résidus organiques à éliminer ;
(c) exécuter ladite étape (1) de façon à ce que ladite vapeur réagisse avec lesdits revêtements, films, couches ou résidus organiques pour former une matière organique physiquement ou chimiquement modifiée ;
(d) exécuter l'étape (2) pour éliminer ladite matière organique desdits substrats ; et
(e) soumettre lesdits revêtements, films, couches ou résidus organiques à un traitement de post-rinçage chimique ou physique après l'étape (2) de façon à éliminer toute matière organique résiduelle desdits substrats restant après ledit rinçage au solvant ;
**caractérisé en ce que** l'étape de traitement à la vapeur est essentiellement constituée par un traitement avec du trioxyde de soufre gazeux anhydre.

2. Procédé selon la Revendication 1, dans lequel ledit substrat est sélectionné dans le groupe constitué par les éléments du Groupe IV, les semi-conducteurs composés III-V, les oxydes, les nitrures, les oxynitrures, les films organiques, les diélectriques organiques, les complexes organométalliques et les polymères, les métaux et les alliages métalliques.

3. Procédé selon la Revendication 1 ou la Revendication 2, comprenant également les étapes consistant à :
(a) soumettre ledit substrat au dit traitement chimique ou physique précurseur ;
(b) placer ledit substrat dans une cuve ;
(c) purger ladite cuve avec un gaz inerte sec ;
(d) introduire ladite vapeur essentiellement constituée par du trioxyde de soufre gazeux anhydre dans ladite cuve pour réagir avec ledit revêtement, film, couche ou résidu ;
(e) laisser passer une période de temps pour permettre la réaction entre ledit trioxyde de soufre et ledit revêtement ; et
(f) terminer ladite réaction entre ledit trioxyde de soufre et ledit revêtement en soumettant ledit substrat à un traitement chimique ou physique à point de virage.

4. Procédé selon l'une quelconque des revendications précédentes, dans lequel (1) ledit traitement chimique précurseur est sélectionné dans le groupe constitué par l'exposition aux gaz de transformation chimiquement actifs, aux gaz de transformation chimiquement inertes et aux solvants, (2) ledit traitement physique précurseur est sélectionné dans le groupe constitué par l'exposition à la chaleur, aux rayonnements électromagnétiques d'une longueur d'onde comprenant les rayonnements ultraviolets, à l'énergie laser, à l'énergie sonore ultrasonique et mégasonique, et (3) ledit traitement chimique ou physique précurseur est exécuté à une température comprise entre la température ambiante et 400 °C.

5. Procédé selon l'une quelconque des revendications précédentes, dans lequel ledit rinçage au solvant est effectué dans un solvant sélectionné dans le groupe constitué par l'eau, les alcanols inférieurs, l'acétone, les acides, les bases, la choline, les solutions à base d'amines et leurs mélanges.

6. Procédé selon l'une quelconque des revendications précédentes, dans lequel ledit rinçage au solvant est simultanément exécuté en présence d'énergie mégasonique ou ultrasonique, de chaleur, de rayonnements électromagnétiques d'une longueur d'onde comprenant les rayonnements ultraviolets ou d'énergie laser.

7. Procédé selon l'une quelconque des revendications précédentes, dans lequel (1) ledit traitement de post-rinçage chimique est sélectionné dans le groupe constitué par une autre exposition aux gaz ou vapeurs de transformation chimiquement actifs, aux gaz de transformation chimiquement inertes et aux solvants, (2) ledit traitement de post-rinçage physique est sélectionné dans le groupe constitué d'une autre exposition à la chaleur, aux rayonnements électromagnétiques d'une longueur d'onde comprenant les rayonnements ultraviolets, à l'énergie laser, à l'énergie cinétique, aux pulvérisateurs d'eau déminéralisée sous pression, au lavage physique, au traitement à la neige carbonique, à l'énergie sonore ultrasonique et mégasonique, et (3) ledit traitement de post-rinçage chimique ou physique est exécuté à une température comprise entre la température ambiante et 400 °C.

8. Procédé selon l'une quelconque des revendications précédentes, dans lequel l'étape (b) comprend également l'exposition simultanée au traitement chimique ou physique sélectionné dans le groupe constitué par d'autres gaz et vapeurs de transformation chimiquement actifs, les gaz de transformation chimiquement inertes, les solvants vaporisés, la chaleur, les rayonnements électromagnétiques d'une longueur d'onde comprenant les rayonnements ultraviolets et l'énergie laser.

9. Procédé selon l'une quelconque des revendications précédentes, dans lequel chacune de ladite étape de soumission est indépendamment effectuée pendant une période de temps pouvant atteindre 5 minutes.

10. Procédé selon l'une quelconque des revendications précédentes, dans lequel lesdits revêtements, films, couches et résidus organiques sont sélectionnés dans le groupe constitué par les matières organiques photosensibles et non photosensibles, les photorésistances polymérisées, les peintures, les résines, les polymères organiques mono- et multicouches, certains complexes organométalliques, une photorésistance optique positive, une photorésistance optique négative, les photorésistances à faisceaux d'électrons, les photorésistances à rayons X, les photorésistances à faisceaux d'ions, les photorésistances à implantation ionique et d'autres photorésistances durcies.

11. Procédé selon l'une quelconque des revendications précédentes, comprenant également l'étape consistant à : soumettre lesdits revêtements, films, couches ou résidus organiques à un traitement de pré-rinçage chimique ou physique après l'étape (b).
